# EUROPÄISCHE PATENTANMELDUNG

(11) **EP 1 308 735 A1**
(43) Veröffentlichungstag der Anmeldung: **07.05.2003**
(21) Anmeldenummer: 01126134.4
(22) Anmeldetag: 02.11.2001
(51) Int. Cl.: G01R 31/3185

(54) **Elektronischer Baustein mit Ausgangsbuffersteuerung**

(71) Anmelder: SIEMENS AKTIENGESELLSCHAFT, 80333 München (DE)
(72) Erfinder: Ghameshlu, Majid, 1110 Wien (AT); Krause, Karlheinz, 82152 Planegg (DE); Taucher, Herbert, 2340 Moedling (AT)

(57) **Zusammenfassung**

Um bei einem elektronischen Baustein (1) mit einer integrierten Schaltung (2), die Ausgangs-FFs (15) aufweist, deren Ausgabedaten im Normalmodus des Bausteins (1) an jeweils einem Ausgangsbuffer (16) des Bausteins (1) weitergegeben werden, die durch ein Steuersignal gesteuert werden, wobei das Steuersignal im Normalmodus von einem dem Ausgangsbuffer (16) zugeordneten Ausgabe-Enable-FF (18) und in einem Scanmodus des Bausteins von den Scan-Enable-Zellen (25) geliefert wird, eine Optimierung des Timings im Normalmodus ohne Nachteile oder Einschränkungen für den Scanmodus vorzusehen, sieht die vorliegende Erfindung eine Vorrichtung vor bei dem im Scanmodus eine Scan-Enable-Zelle (25) mindestens zwei Ausgangsbuffer (16) steuert.

## Beschreibung

Die Erfindung bezieht sich auf einen elektronischen Baustein mit einer integrierten Schaltung, die Ausgangs-Flip-Flops aufweist, deren Ausgabedaten im Normalmodus des Bausteins an jeweils einem Ausgangsbuffer des Bausteins weitergegeben werden, die durch ein Steuersignal gesteuert werden, wobei das Steuersignal im Normalmodus von einem dem Ausgangsbuffer zugeordneten Ausgabe-Enable-Flip-Flop und in einem Scanmodus des Bausteins von den Scan-Enable-Zellen geliefert wird.

Elektrische Bausteine dieser Art werden häufig als Application Specific Integrated Circuits (ASICs) ausgebildet, die nach ihrer Herstellung umfangreichen Qualifizierungsverfahren unterzogen werden. ASICs sind eine Ansammlung von Schaltungen mit einfachen Funktionen, wie Flipflops, Invertierern, NANDs und NORs, sowie von komplexeren Strukturen wie Speicheranordnungen, Addierern, Zählern und Phasenregelschleifen. Die verschiedenen Schaltungen werden in einem ASIC kombiniert, um eine bestimmte Anwendung durchzuführen. Hierbei werden ASICs in einer Vielzahl von Produkten wie z.B. Konsumprodukten, wie Videospielen, digitaler Kameras, in Fahrzeugen und PCs, sowie in Highend Technologie Produkten, wie Workstations und Supercomputern eingesetzt.

Um die Funktionalität des ASICs zu prüfen, sind verschiedene "Design For Test" (DFT)-Verfahren bekannt. Der Vorteil von DFT-Verfahren liegt darin, daß bereits bei der Konstruktion des Bausteins Schaltungselemente eingefügt werden, die ein späteres scan-basiertes Testen ermöglicht, die Anzahl der benötigten Testpunkte auf dem Board des ASICs reduziert und zugleich das Problem von nicht-vorhandener Zugriffspunkten auf dem Chip umgeht.

Ein Beispiel für solch ein DFT-Verfahren ist der sogenannte Boundary-Scan (BS), das ein nach IEEE 1149 standardisiertes Verfahren für Chip- und Boardtests ist. Details zum Boundary-Scan werden z.B. in dem Buch "Boundary-Scan-Test: A Practical Approach", H. Bleeker, Kluwer Academic Publishers 1993, ISBN 0-7923-9296-5 beschrieben. Auf dem Boundary-Scan-Verfahren basieren alle Verbindungstest auf Boardebene in der Produktion von komplexen Printed Circuit Boards (PCBs). Aus diesem Grund wird dieser Standard auch in anderen Integrated Circuits und ASICs implementiert. Aufgrund der Hardware-Vorleistungen, die für den Boundary-Scan getroffen werden, ergeben sich jedoch auch gewisse Einschränkungen hinsichtlich des Eingabe- und Ausgabe-Timings im Normalbetrieb des Bausteins, insbesondere bei timing-kritischen Schnittstellen.

Bei einer klassischen Chipanordnung bilden zwei Chips (Chip A und Chip B) auf einem Board ein Interface, wobei ein einzelner Datenpfad des Interfaces von einem Ausgangs-Flipflop, kurz Ausgangs-FF über den Multiplexer einer Boundary-Scan-Ausgangszelle, einem Input/Output-(I/O)-Buffer, das Board, einem Eingangsbuffer des Chips B zum eintaktenden Eingangs-FF führt.

Bei dieser klassischen Anordnung ergeben sich zwei Anforderungen bezüglich des Timings:
1. Die maximale Laufzeit vom letzten Flipflop im Chip A bis zum ersten Flipflop im Chip B muß eingehalten werden, was eine Beschränkung der Laufzeit vom Flipflop im Chip A bis zum Ausgangspin am Chip A bedeutet.
2. Die Abweichung der einzelnen Datenpfade, d.h. der Skew, des Interfaces dürfen definierte Grenzen nicht überschreiten. Der Skew bezeichnet im Allgemeinen bei einem Datenbus den ungewollten Laufzeitunterschied zwischen dem langsamsten und dem schnellsten Signal auf einem Datenbus.

Da die Deep-Submicron-Effekte bei Chip-Technologien mit gezeichneten Strukturbreiten von 0,25 µm (und darunter) bewirken, daß die Laufzeiten der Leitungen am Chip die Verzögerungen der einzelnen Gatter dominieren, wird angestrebt im Layout des Chips, das letzte Flipflop eines Ausgangs (und dem nachfolgenden Multiplexer) möglichst nahe an den I/O-Buffer zu plazieren. Dies gilt ebenso für das Ausgabe-Enable-Flipflop, kurz Ausgabe-Enable-FF, das in der klassischen Anordnung alle I/O-Buffer eines Chips steuert. Hierbei ist anzumerken, daß im Folgenden der Begriff Ausgangsbuffer als Synonym für I/O-Buffer benutzt wird.

Ein Problem entsteht nun dadurch, daß die I/O-Buffer eines breiteren Interfaces über eine Kante des Chips verteilt sind, und somit die Pfade der Ausgabe-Enable-FFs zu den I/O-Buffern unterschiedliche Laufzeiten haben. Das letzte Flipflop im Enable-Pfad kann nun also nicht mehr optimal für alle I/O-Buffer, sondern nur für einen Buffer der von dem Ausgabe-Enable-FF gesteuerten Gruppe von I/O-Buffern, plaziert werden.

Zur Durchführung des Boundary-Scans sind Boundary-Scan-Zellen zwischen den letzten bzw. ersten Flipflops der Chips und den I/O-Buffern, sowie zwischen den Ausgabe-Enable-FFs und den I/O-Buffern vorgesehen, die in einem Scanmodus zu einem Schieberegister zusammen geschaltet werden können. Auch im Scanmodus werden die I/O-Buffer gesteuert, doch spielen die Laufzeitprobleme (wie oben bezüglich des Normalbetriebs beschrieben) im Scanmodus eine untergeordnete Rolle, da die Betriebsfrequenz im Scanmodus im Bereich eines Zehntels (typischerweise 12,5 MHz) der Taktfrequenz für den Normalmodus liegt.

Die Laufzeitproblematik tritt erst bei Anwendung und Implementierung von timing-kritischen Interfaces auf, wobei man in den kritischen Bereich bei einer Busfrequenz von 133 MHz gelangt. Aufgrund der immer höher werdenden Taktfrequenzen dürften in der Zukunft jedoch zeitkritische Schnittstellen in Integrated Circuits, insbesondere in ASICs, die Regel sein.

Um das Problem von unterschiedlichen Laufzeiten zu umgehen ist es bekannt für jeden Datenpfad des Interfaces ein separates Ausgabe-Enable-FF mit nachfolgender Boundary-Scan-Zelle vorzusehen, die genau einen zugewiesenen I/O-Buffer steuern. Diese Architektur löst zwar auf den ersten Blick das primäre Problem des I/O-Timings, da die einzelnen Ausgabe-Enable-FFs den Timing-Kriterien entsprechend angeordnet werden können, wirft jedoch ein großes Problem hinsichtlich der Testlaufzeiten auf, da die Boundary-Scan-Kette durch die den zusätzlichen Ausgabe-Enable-FFs zugeordneten Boundary-Scan-Zellen wesentlich länger wird. Darüber hinaus ist die entsprechende zusätzliche Hardware zur Durchführung des Boundary-Scan-Tests zu implementieren und die Simulationszeiten erhöhen sich.

Zur Verdeutlichung der Abhängigkeit der Simulationslaufzeit von der Anzahl der Ausgabe-Enable-FFs wird im Folgenden ein Beispiel gegeben: Angenommen eine SDRAM-Schnittstelle mit insgesamt 52 Adresspins, 134 Datenpins, 18 ECC-Pins und einigen Steuerpins benötigt in der oben beschriebenen klassischen Anordnung, d.h. in der Anordnung in der Laufzeitprobleme auftreten können, 12 Ausgabe-Enable-FFs, wovon 9 für Datenpins eingesetzt werden. Der betrachtete Chip hat insgesamt 1291 Boundary-Scan-Zellen, davon sind 757 Boundary-Scan-Ausgangszellen.

Für einen vollständigen Test der korrekten Verdrahtung per Simulation müssen unter anderem jeweils alle Ausgabe-Enable-FFs bis auf eines durch einen Schiebezyklus, der so viele Takte benötigt, wie die Länge der Boundary-Scan-Kette beträgt (1292 Takte) mit "1" vorgeladen werden, um mit einem sogenannten "Extest" das tatsächliche Enablen bzw. Aktivieren der dazugehörigen Pins zu verifizieren. Für die Pins des SDRAM-Interface sind insgesamt also 12 Schiebezyklen notwendig, im Vergleich dazu sind 87 Schiebezyklen notwendig, um den gesamten Chip zu verifizieren.

Teilt man nun auch noch jedem Datenausgangspin ein eigenes Ausgabe-Enable-FF zu, um die wie oben beschrieben Laufzeitprobleme im Normalbetrieb zu umgehen, so würde die Anzahl der Daten-Enables von 9 auf 134 steigen. Insgesamt wären nun also 212 Schiebezyklen notwendig, was eine Steigerung der Simulationszeit um einen Faktor von 2,43 bedeutet. Zu beachten ist, daß hier nur ein Interface betrachtet wurde.

Ein weiteres Beispiel zeigt die Abhängigkeit der Testlaufzeit bei der Baugruppenfertigung von der Anzahl der Ausgabe-Enable-FFs: Als Beispiel wird hier der ASIC MECA mit 1294 Boundary-Scan-Zellen, 672 Boundary-Scan-Ausgabezellen und 71 Boundary-Scan-Enable-Zellen, d.h. Boundary-Scan-Zellen zum Steuern der I/O-Buffer im Scanmodus angeführt. Da für jede Boundary-Scan-Ausgangszelle eine Boundary-Scan-Enable-Zelle vorgesehen wird, erhöht sich die Länge der Boundary-Scan-Kette um 672 - 71 = 601 auf 1294 + 601 = 1895 Boundary-Scan-Zellen. Damit erhöht sich die Länge der Boundary-Scan-Kette um 46% und die Testzeit um etwa den gleichen prozentualen Betrag.

Daraus ist es ersichtlich, daß es nötig ist die Anzahl der Boundary-Scan-Zellen und insbesondere von Boundary-Scan-Enable-Zellen zu minimieren.

Der Erfindung liegt daher das Problem zugrunde, einen elektronischen Baustein zu schaffen, bei dem keine Laufzeitund Skew-Probleme auftreten, und der Hardware- und Designaufwand für das Boundary-Scan-Verfahren dennoch möglichst gering gehalten wird.

Diese Aufgabe wird erfindungsgemäß durch einen elektronischen Baustein gelöst, bei dem im Scanmodus eine Scan-Enable-Zelle mindestens zwei Ausgangsbuffer steuert.

Dadurch ist es möglich, die Laufzeit vom ausgangsseitig letzten Flipflop des Daten- und Enablepfades zum Pin zu minimieren und zu balancieren, ohne einen Clock-Baum für diese Netze einfügen zu müssen und ohne daß sich die Test-, Simulations- und Testerzeiten verlängern.

Bei einer vorteilhaften Ausgestaltung der vorliegenden Erfindung sind zwischen den Ausgangs-FFs und ihren jeweiligen Ausgangsbuffern Boundary-Scan-Zellen angeordnet, die im Scanmodus zu einem Schieberegister zusammengeschaltet werden können. Dadurch wird die volle Boundary-Scan-Funktionalität erreicht.

Gemäß einer anderen vorteilhaften Ausführungsform ist jeder Ausgabe-Enable-FF über einen Steuermultiplexer mit einem Ausgangsbuffer verbunden, um die separate Steuerung der Ausgangsbuffer im Scan- und Normalmodus vorzusehen.

Gemäß einem vorteilhaften Aspekt der vorliegenden Erfindung liefert der Steuermultiplexer im Normalmodus das Steuersignal des Ausgabe-Enable-FFs an den Ausgangsbuffer und im Scanmodus das Steuersignal einer Scan-Enable-Zelle an den Ausgangsbuffer, was eine modusabhängige Steuerung der Ausgangsbuffer vorsieht.

Gemäß einer besonders vorteilhaften Ausführungsform der vorliegenden Erfindung weisen die Scan-Enable-Zellen einen ersten Steuerausgang zum Steuern eines Ausgangsbuffers und einen zweiten Steuerausgang zum Steuern von zumindest einem weiteren Ausgangsbuffer auf. Dadurch können die erfindungsgemäßen Scan-Enable-Zellen mehrere Ausgangsbuffer steuern, doch entsprechen besitzen gleichzeitig die dem IEEE 1149 Standard entsprechende Boundary-Scan-Zellen Funktionalität.

Gemäß einer weiteren besonders vorteilhaften Ausführungsform der vorliegenden Erfindung ist die Scan-Enable-Zelle eine einem Ausgabe-Enable-FF zugeordnete Boundary-Scan-Zelle mit zwei Steuerausgängen um ausgehend von aus dem Standard IEEE 1149 bekannten Boundary-Scan-Zellen die vorliegenden Erfindung vorzusehen.

Gemäß einer anderen Ausführungsform der vorliegenden Erfindung ist der Steuermultiplexer des Ausgabe-Enable-FF, der eine Scan-Enable-Zelle zugeordnet ist, der Ausgangsmultiplexer der Boundary-Scan-Zelle ist, um so einen zusätzliches Bauteil, nämlich einen Steuermultiplexer einzusparen und die Scan-Enable-Zelle in das Schieberegister zu integrieren.

Vorteilhafterweise ist der zusätzliche Steuerausgang der Scan-Enable-Zelle über Buffersteuerleitungen mit zumindest einem Steuermultiplexer eines weiteren Ausgangsbuffers verbunden. Hierdurch wird es möglich, daß die Scan-Enable-Zelle eine Zahl von Ausgangsbuffern im Scanmodus steuert, die größer ist als die Zahl der im Normalmodus von einem Ausgabe-Enable-FF gesteuerten Ausgangsbuffer.

Gemäß einer besonders vorteilhaften Ausführungsform der vorliegenden Erfindung werden die Boundary-Scan-Zellen im Scanmodus mit den Scan-Enable-Zellen zu einem einzigen Schieberegister zusammengeschaltet um ein Schieberegister zum Testen aller Scan-Zellen vorzusehen.

Bei einer anderen vorteilhaften Ausführungsform erhält der Steuermultiplexer, von einem zentralen Controller ausgehend, Modussteuersignale über Modussteuerleitungen. Damit wird eine besonders einfach zu implementierende Steuerung der Steuermultiplexer vorgesehen.

Bei einer anderen weiteren Ausführungsform werden alle Steuermultiplexer durch die Modussteuersignale in den gleichen Zustand geschaltet. Damit wird eine einheitliche Steuerung der Ausgangsbuffer durch die Scan-Enable-Zellen im Scanmodus und durch die Ausgabe-Enable-FF im Normalbetrieb ermöglicht.

Bei einer anderen weiteren Ausführungsform steuern die selben Modussteuersignale, die die Steuermultiplexer steuern, auch die Multiplexer der Boundary-Scan-Zellen, die bestimmen, ob Daten aus den Ausgabe-FFs oder eingeschobenen Daten aus dem Schieberegister über die Ausgabebuffer ausgegeben werden. Dadurch kann die Steuerung der Steuermultiplexer besonders einfach mit der Steuerung der Boundary-Scan-zellen kombiniert werden.

Ein Ausführungsbeispiel der Erfindung ist in der Zeichnung dargestellt und wird im folgenden näher beschrieben. Die einzige Figur der Anmeldung zeigt eine schematische Darstellung eines elektronischen Bausteins gemäß der vorliegenden Erfindung.

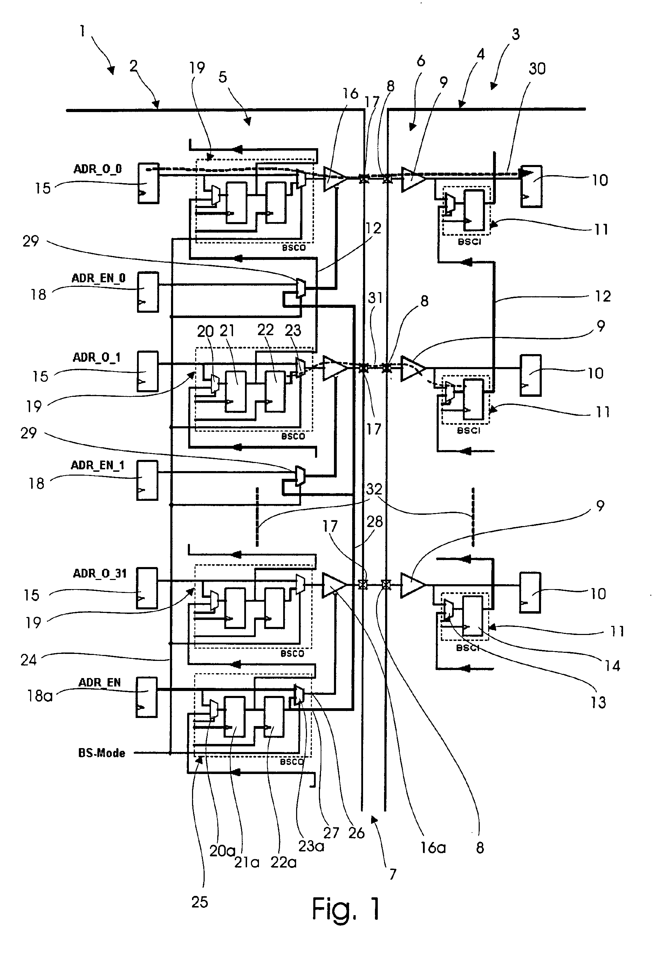

Die Fig. 1 zeigt einen ersten erfindungsgemäßen elektronischen Baustein 1 mit einer integrierten Schaltung 2 und einem zweiten elektronischen Baustein 3 ebenfalls mit einer integrierten Schaltung 4. Bei den elektronischen Bausteinen handelt es sich im vorliegenden Fall um Application Specific Integrated Circuits (ASICs), die im allgemeinen einen ASIC-Core, einen Eingabebereich und einen Ausgabebereich umfassen. In der Fig. 1 ist lediglich der Ausgabebereich 5 des ersten elektronischen Bausteins 1, sowie der Eingabebereich 6 des zweiten elektronischen Bausteins 3 dargestellt.

Die beiden elektronischen Bausteine 1, 3 sind über ein Interface 7, das durch die Adressen ADR_O_0 bis ADR_O_31 definiert ist, auf einem Board (nicht dargestellt) mit einander Verbunden. Das Interface 7 dient zum Datenaustausch zwischen den Bausteinen bzw. ASICs 1, 3.

Der Eingabebereich 6 des zweiten ASICs 3 umfaßt Eingangspins 8, die jeweils verbunden sind mit Eingangsbuffern 9, und diese wiederum sind verbunden mit Eingangs-FFs 10. Die eintaktenden Eingangs-Flipflops 10 bzw. Eingangs-FFs geben die eingegebenen und abgetakteten Daten an den nicht-dargestellten ASIC-Core weiter, wobei im Allgemeinen die Eingangs-FFs 10 zum Core gehören. Zwischen den Eingangsbuffern 9 und Eingangs-FFs 10 befinden sich jeweils parallel geschaltete Boundary-Scan-Eingangszellen 11. Die Boundary-Scan-Eingangszellen 11 (BSCI) entsprechen dem IEEE 1149 Standards und können im Scanmodus über Schieberegisterleitungen 12 zu einem Schieberegister geschaltet werden, um an den Eingangspins 8 angelegte Testdaten aufzunehmen und über das gebildete Schieberegister die Testdaten zur Analyse auszuschieben. Hierbei werden Eingangsdaten zunächst in BSCI-Flipflops 14 der BSCIs 11 aufgenommen. Anschließend wird zum Bilden des Schieberegisters BSCI-Multiplexer 13 so geschaltet, das die BSCIs über Schieberegisterleitungen 12 das Schieberegister bilden.

Im Ausgabebereich 5 des ASICs 1 befinden sich Ausgangs-FFs 15, die Daten, die der ASIC-Core ausgibt, von nicht-dargestellten vorhergehenden Schaltelementen erhalten. Die Ausgangs-FFs 15 gehören im Allgemeinem zum ASIC-Core und sind mit Input/Output-Buffern bzw. I/O-Buffern 16 verbunden. Die I/O-Buffer 16 sind im bevorzugten Ausführungsbeispiel Tristate-Ausgangsbuffer 16. Im folgenden wird auf sie lediglich mit Ausgangsbuffer Bezug genommen, es ist jedoch anzumerken, daß auch andere z.B. bidirektionale Buffer im Rahmen der vorliegenden Erfindung eingesetzt werden können. Die Ausgangsbuffer 16 können die logischen Zustände 1, 0 sowie einen Hochimpedanzzustand Z einnehmen.

Die Ausgangsbuffer 16 sind mit Ausgangspins 17 verbunden, wodurch einen Datenweitergabe aus den ASIC 1 und weiter an den zweiten ASIC 3 ermöglicht wird. Die Ausgangsbuffer 16 haben einen Enable-Eingang der über einen später beschriebenen Steuermultiplexer 29 mit einem jeweiligen Ausgabe-Enable-FF 18, 18a verbunden ist. Die Ausgabe-Enable-FF 18, 18a steuern durch ein Steuersignal im Normalbetrieb des ASIC 1 den Zustand der Ausgangsbuffer 16. Die Ausgabe-Enable-FFs 18 erhalten ihre Daten ebenso wie die Ausgangs-FFs 15 von vorgelagerten nicht-dargestellten Schaltelementen des elektronischen Bausteins 1 und werden im allgemeinen dem ASIC-CORE zugeordnet.

Zwischen den Ausgangs-FFs 15 und den Ausgangsbuffern 16 sind Boundary-Scan-Ausgangszellen (BSCO) 19 angeordnet. Die BSCO 19 entsprechen dem IEEE 1149 Standard und umfassen daher einen BSCO-Eingangsmultiplexer 20, einen ersten BSCO-Flipflop 21, einen zweiten BSCO-Flipflop 22 sowie einen BSCO-Ausgangsmultiplexer 23. Der BSCO-Eingangsmultiplexer 20 gibt je nach Zustand entweder eingeschobene Daten oder Daten aus den Ausgangs-FF 15 in den ersten BSCO-Flipflop 21 ein. Dieser gibt die Daten einerseits über Schieberegisterleitungen 12 an den BSCO-Eingangsmultiplexer 20 der benachbarten, im Schieberegister nachfolgenden BSCO 19 weiter und andererseits an den zweiten BSCO-Flipflop 22. Der BSCO-Flipflop 22 Ausgang, sowie die Ausgabe des Ausgangs-FF 15 liefern die Eingaben für den BSCO-Ausgangsmultiplexer 23, so daß Multiplexer 23, wenn dieser in den Scanmodus geschaltet ist, die Daten aus dem zweiten BSCO-Flipflop 22 oder im Normalbetrieb die Ausgaben des Ausgangs-FF über den Ausgangsbuffer 16 ausgibt.

Für eine genauere Beschreibung der Funktionsweise einer BSCO wird auf den IEEE 1149 Standard verwiesen. Es sei hier jedoch bemerkt, daß der BSCO-Ausgangsmultiplexer 23 über Modussteuerleitungen 24 ein Modussteuersignal von einem nicht-dargestellten Tap-Controller erhält. Das Modussteuersignal bestimmt, ob Daten aus den Ausgangs-FFs 15 oder ggf. als Testvektoren in die BSCO 19 eingeschobene Daten aus den zweiten BSCO-Flipflops 22 an die Ausgangsbuffer 16 weitergegeben werden.

Gemäß der vorliegenden Erfindung wird zwischen einem Ausgabe-Enable-FF 18a, der mit ADR_EN in der Fig. 1 bezeichnet ist, und dem dazugehörigen Ausgangsbuffers 16a eine adaptierte BSCO 25 geschaltet, die im Folgenden als Scan-Enable-Zelle 25 bezeichnet wird. Die Scan-Enable-Zelle 25 dient zur Steuerung der Ausgangsbuffer 16 des ASICs 1 in einem Scanmodus des ASICs 1, wobei bei dem bevorzugten Ausführungsbeispiel der Scanmodus ein Boundary-Scan gemäß des IEEE 1149 Standards ist, aber auch ein beliebiges, anderes Scan-Verfahren zum Überprüfen der ASICs 1 sein kann.

Die Scan-Enable-Zelle 25 ist baugleich mit dem BSCO 19, und weist insofern einen Eingangsmultiplexer 20a, einen ersten Flipflop 21a, einen zweiten Flipflop 22a, sowie einen Ausgangsmultiplexer 23a auf, die ähnliche Funktionen übernehmen wie deren BSCO Äquivalente. Der Eingangsmultiplexer 20a liefert jedoch entweder Ausgangsbuffersteuerdaten aus dem Ausgabe-Enable-FF 18a oder eingeschobene Daten an den ersten Flipflop 21a.

Die Scan-Enable-Zelle der vorliegenden Erfindung weist weiterhin einen ersten Steuerausgang 26 und einen zweiten Steuerausgang 27 auf. Die Ausgabe des Ausgangsmultiplexer 23a ist mit dem ersten Steuerausgang 26 verbunden und liefert ein Steuersignal an den Enable-Eingang des Ausgangsbuffers 16a. Im Normalmodus ist der Ausgangsmultiplexer 23a durch das Modussteuersignal so geschaltet, daß ein Steuersignal des Ausgabe-Enable-FFs 18a an dem Ausgangsbuffer 16a anliegt und diesen steuert. Im Scanmodus ist der Ausgangsmultiplexer 23a durch das Modussteuersignal so geschaltet, daß Daten aus dem zweiten Flipflop 22a der Scan-Enable-Zelle 25 an den Ausgangsbuffer 16 als Steuersignal angelegt werden.

Der zweite Steuerausgang 27 verbindet den zweiten Flipflop 22a der Scan-Enable-Zelle 25 über Buffersteuerleitungen 28 mit den verbleibenden Ausgangsbuffern 16, d.h. mit den Ausgangsbuffern 16, die nicht über den ersten Steuerausgang 26 gesteuert werden.

Zwischen den Ausgangsbuffern 16, die nicht über den ersten Steuerausgang 26 gesteuert werden, und den zu den jeweiligen Ausgangsbuffer 16 gehörenden Ausgabe-Enable-FF 18 ist jeweils ein Steuermultiplexer 29 angeordnet. Der Steuermultiplexer 29 erhält als Eingaben das Steuersignal des Ausgabe-Enable-FFs 18 und das Steuersignal des zweiten Flipflops der Scan-Enable-Zelle 25. Je nach Zustand des Steuermultiplexers 29 wird eines der beiden Steuersignale an den jeweiligen Ausgangsbuffer 16 zu dessen Steuerung weitergeleitet. Dies bedeutet das während im Normalbetrieb jeweils ein Ausgabe-Enable-FF 18 ein Ausgangsbuffer 16 steuert, kontrolliert im Scanmodus die Scan-Enable-Zelle alle Ausgangsbuffer 16.

Der nicht-dargestellte Tap-Controller steuert im bevorzugten Ausführungsbeispiel durch Senden des Modussteuersignals über die Modussteuerleitungen 24 den Zustand des Steuermultiplexers 29. Somit liegt an den Steuermultiplexern 29 dasselbe Modussignal wie an den BSCO-Ausgangsmultiplexern 23 und dem Ausgangsmultiplexer 23a und sind bevorzugterweise alle in den selben Zustand geschaltet.

Im Folgenden werden nun die verschiedenen Betriebsmodi der ASICs beschrieben:
(A) Im Normalmodus erhalten die Ausgangs-FFs 15 Daten für die Ausgabe aus dem ersten ASIC 1 und Eingabe in den zweiten ASIC 3. Der Datenpfad für den Normalbetrieb ist in der Fig. 1 beispielhaft für die Adresse ADR_O_0 durch den Pfeil 30 dargestellt. Die Daten aus dem Ausgangs-FF 15 gelangen zu dem Ausgangsbuffer 16, da der BSCO-Ausgangsmultiplexer 23 nicht für den Scanmodus aktiviert ist. Der Ausgabe-Enable-FF 18 (ADR_EN_0) sendet im Normalbetrieb ein Steuersignal an den Ausgangsbuffer 16, da der Steuermultiplexer 29, wiederum nicht in den Scanmodus geschaltet ist. Wenn das Steuersignal des Ausgabe-Enable-FFs 18 den Ausgangsbuffer 16 aktiviert hat, gelangen die aus dem Ausgangs-FF 15 ausgegebenen Daten über den Ausgangspin 17 und das Interface 7 zum Eingangspin 8 des zweiten ASICs 3. Die Daten werden nun im folgenden im Eingangs-FF 10 des zweiten ASICs 3 abgetaktet.
(B) Im Scanmodus werden die ASICs 1,3 nach ihrer Herstellung getestet. Im bevorzugten Ausführungsbeispiel ist der Scanmodus ein Boundary-Scan-Test, wobei ein Verbindungstest der Ausgänge bzw. Eingänge der Bausteine 1, 3 stattfindet. Hierfür werden die BSCO 19 und die BSCI 11 sowie die Scan-Enable-Zellen 25 eines Bausteins zu einem Schieberegister durch Steuerung der BSCO-Eingangsmultiplexer 20, der BSCI-Multiplexer 13 und des Eingangsmultiplexers 20a der Scan-Enable-Zelle 25 zu einem Schieberegister geschaltet. Hierbei sind die BSCOs 19, BSCIs 11 und die mindestens eine Scan-Enable-Zelle 25 durch die Schieberegisterleitungen 12 verbunden. Mit einer Taktung von typischerweise 12,5 MHz, die ungefähr einem Zehntel der Taktung des Normalbetriebs entspricht, werden nun Testvektoren in das Schieberegister eingeschoben und gelangen in den zweiten BSCO-Flipflop 23 sowie in den zweiten Flipflop der Scan-Enable-Zelle 25. Der Datenfluß im Scanmodus über das Interface 7 ist beispielhaft durch den Pfeil 31 in der Fig. 1 dargestellt. Die Daten aus dem zweiten BSCO-Flipflop 22 gelangen vorbei an den BSCO-Ausgangsmultiplexer 23 zu dem Ausgangsbuffer 16, da der BSCO-Ausgangsmultiplexer 23 über die Modussteuerleitungen 24 in den Scanmodus geschaltet ist. Vom Ausgangsbuffer 16 gelangen die Daten weiter über das Interface 7 zum Eingangsbuffer 9 des zweiten elektronischen Bausteins 3. Dort gelangen die Daten über den in den Scanmodus geschalteten BSCI-Multiplexer 13 und in den BSCI-Flipflop 14. Nachdem die Daten von dem ASIC 3 empfangenen und in den BSCI 19 eingespeichert wurden, kann durch Umschalten der BSCI-Multiplexer 13 das Schieberegister hergestellt werden und hierüber aus dem ASIC 3 zur Analyse ausgelesen werden.

Zusammenfassend kann festgestellt werden, daß im Normalmodus die Ansteuerung eines Ausgangsbuffers 16 von jeweils einem zugeordneten Ausgabe-Enable-Flipflop 18 erfolgt. Das bringt den Vorteil, daß dieses das Flipflop 18 mit den nachfolgenden dazugehörigen Steuermultiplexer 29 optimal in unmittelbarer Nähe des Ausgangsbuffers 16 plaziert werden kann. Nur so ist es möglich, die Laufzeiten vom ausgangsseitig letzten Flipflop des Daten-Enable bzw. -Steuerpfades zum Ausgangspin 17 zu minimieren und zu balancieren ohne einen Clock-Tree bzw. Taktbaum für diese Netze einfügen zu müssen.

Im Scanmodus dagegen wird eine Gruppe von Ausgangsbuffern 16 von einer Scan-Enable-Zelle 25 angesteuert. Dies hat zur Folge, daß sich die Test-, Simulations- und Testerzeiten im Vergleich zu herkömmlichen Implementierungen nicht verlängern, da keine zusätzlichen BSCO-Zellen implementiert werden müssen.

Durch die Schaffung der Scan-Enable-Zellen 25, die jeweils die Ansteuerung einer Gruppe von Ausgangsbuffern 16 im Scanmodus, insbesondere im Boundary-Scanmodus, übernehmen und durch die Verwendung jeweils eines Ausgabe-Enable-Flipflops 18 mit einem nachfolgenden Steuermultiplexer 29 zur Ansteuerung der Ausgangsbuffer 16 im Normalmodus, schafft man für das Layout des elektronischen Bausteins 1 die besten Voraussetzungen für eine Optimierung des Timings im Normalmodus ohne Nachteile oder Einschränkungen für den Scanmodus.

Solch eine Berücksichtigung des Layouts gewinnt bei neueren Technologien im Halbleitersektor an Bedeutung, was aus dem zunehmenden Einsatz von "Physical Compile"-Tools bereits bei der Schaltungssynthese zu entnehmen ist.

Schlußendlich ist zu bemerken, daß in Figur 1 lediglich ein Ausschnitt eines Interfaces zwischen zwei ASICs dargestellt ist. Die gepunkteten Linien 32 sollen andeuten, das die aus Ausgangs-FFs 15, Ausgabe-Enable-FFs 18, BSCOs 19, Ausgangsbuffern 16, Scan-Enable-Zelle 25 , Steuermultiplexer 29 und Verbindungen gebildete Gruppe eine beliebige Anzahl von Elementen nach dem in Figur 1 offenbarten Schema umfassen kann. Gleiches gilt für die Gruppe von BSCIs 11 in dem ASIC 3.

In dem bevorzugten Ausführungsbeispiel der vorliegenden Erfindung ist in einer Gruppe nur eine Scan-Enable-Zelle 25 vorgesehen, die alle Ausgangsbuffer 16 der Gruppe im Normalmodus steuert. Es sind jedoch auch durchaus so große Gruppen denkbar, in denen selbst bei der vergleichsweise niedrigen Taktung im Scanmodus, die Steuerung der Ausgangsbuffer 16 im Scanmodus auf mehrere Scan-Enable-Zellen 25 aufgeteilt wird um eine Optimierung des Timings der Ansteuerung der Ausgangsbuffer zu ermöglichen.

Wie der Fachmann leicht nachvollziehen kann, können auch mehrere der in Figur 1 dargestellten Gruppe in einem Interface parallel zueinander angeordnet sein, d.h. jeweils ein Scan-Enable 25 bedient eine Gruppe von Ausgangsbuffern 16 und mehrere dieser Gruppen bilden zusammen den Ausgangsbereich 5 des ASICs.

## Patentansprüche

1. Elektronischer Baustein (1) mit einer integrierten Schaltung (2), die Ausgangs-FFs (15) aufweist, deren Ausgabedaten im Normalmodus des Bausteins (1) an jeweils einem Ausgangsbuffer (16) des Bausteins (1) weitergegeben werden, die durch ein Steuersignal gesteuert werden, wobei das Steuersignal im Normalmodus von einem dem Ausgangsbuffer (16) zugeordneten Ausgabe-Enable-FF (18) und in einem Scanmodus des Bausteins von den Scan-Enable-Zellen (25) geliefert wird, wobei im Scanmodus eine Scan-Enable-Zelle (25) mindestens zwei Ausgangsbuffer (16) steuert.

2. Elektronischer Baustein (1) nach Anspruch 1,
**dadurch gekennzeichnet,**
**daß** zwischen den Ausgangs-FFs (15) und ihren jeweiligen Ausgangsbuffern (16) Boundary-Scan-Zellen (19) angeordnet sind, die im Scanmodus zu einem Schieberegister zusammengeschaltet werden.

3. Elektronischer Baustein (1) nach einem der vorhergehenden Ansprüche,
**dadurch gekennzeichnet,**
**daß** jeder Ausgabe-Enable-FF über einen Steuermultiplexer (29) mit einem Ausgangsbuffer (16) verbunden ist.

4. Elektronischer Baustein (1) nach einem der vorhergehenden Ansprüche,
**dadurch gekennzeichnet,**
**daß** der Steuermultiplexer (29) im Normalmodus das Steuersignal des Ausgabe-Enable-FFs (18) an den Ausgangsbuffer (16) und im Scanmodus das Steuersignal einer Scan-Enable-Zelle (19) an den Ausgangsbuffer (16) liefert.

5. Elektronischer Baustein (1) nach einem der vorhergehenden Ansprüche,
**dadurch gekennzeichnet,**
**daß** die Scan-Enable-Zellen (25) einen ersten Steuerausgang (26) zum Steuern eines Ausgangsbuffers (16a) und einen zweiten Steuerausgang (27) zum Steuern von zumindest einem weiteren Ausgangsbuffer (16) aufweisen.

6. Elektronischer Baustein (1) nach einem der vorhergehenden Ansprüche,
**dadurch gekennzeichnet,**
**daß** die Scan-Enable-Zelle (25) eine einem Ausgabe-Enable-FF (18) zugeordnete, Boundary-Scan-Zelle mit zwei Steuerausgängen (26, 27) ist.

7. Elektronischer Baustein (1) nach Anspruch 6,
**dadurch gekennzeichnet,**
**daß** der Steuermultiplexer (23a) des Ausgabe-Enable-FF (18), der eine Scan-Enable-Zelle (25) zugeordnet hat, der Ausgangsmultiplexer (23a) der Boundary-Scan-Zelle (25) ist.

8. Elektronischer Baustein (1) nach einem der vorhergehenden Ansprüche,
**dadurch gekennzeichnet,**
**daß** der zusätzliche Steuerausgang (27) der Scan-Enable-Zelle (25) über Buffersteuerleitungen (28) mit zumindest einem Steuermultiplexer (29) eines weiteren Ausgangsbuffers (16) verbunden ist.

9. Elektronischer Baustein (1) nach einem der vorhergehenden Ansprüche,
**dadurch gekennzeichnet,**
**daß** der Scanmodus ein Boundary-Scan gemäß des in IEEE 1149 standardisierten Verfahrens ist.

10. Elektronischer Baustein (1) nach einem der vorhergehenden Ansprüche,
**dadurch gekennzeichnet,**
**daß** die Boundary-Scan-Zellen (19) im Scanmodus mit den Scan-Enable-Zellen (25) zu einem einzigen Schieberegister zusammengeschaltet werden.

11. Elektronischer Baustein (1) nach einem der vorhergehenden Ansprüche,
**dadurch gekennzeichnet,**
**daß** die Steuermultiplexer (29), von einem zentralen Controller ausgehend, Modussteuersignale über Modussteuerleitungen (24) erhalten.

12. Elektronischer Baustein (1) nach einem der vorhergehenden Ansprüche,
**dadurch gekennzeichnet,**
**daß** die Steuermultiplexer (29) durch die Modussteuersignale alle in den gleichen Zustand geschaltet werden.

13. Elektronischer Baustein (1) nach einem der vorhergehenden Ansprüche,
**dadurch gekennzeichnet,**
**daß** die selben Modussteuersignale, die die Steuermultiplexer (29) steuern, auch die Multiplexer (23) der Boundary-Scan-Zellen (19), die bestimmen, ob Daten aus den Ausgabe-FFs (15) oder eingeschobenen Daten aus dem Schieberegister über die Ausgabebuffer (16) ausgegeben werden, steuern.
